# EUROPEAN PATENT APPLICATION

(11) **EP 1 258 956 A2**
(43) Date of publication of application: **20.11.2002**
(21) Application number: 02250167.0
(22) Date of filing: 10.01.2002
(51) Int. Cl.: H01S 5/0683, G11B 7/125

(54) **Laser diode output control apparatus**

(30) Priority: 17.05.2001 KR 2001026962
(71) Applicant: SAMSUNG ELECTRONICS CO., LTD., Suwon-City, Kyungki-do (KR)
(72) Inventor: Seo, Jin-gyo, Jangan-gu, Suwon-si, Gyeonggi-do (KR)
(74) Representative: Robinson, Ian Michael

(57) **Abstract**

An optical recording/reproducing apparatus, and more particularly, a laser diode output control apparatus capable of controlling an output of a laser diode so that it is at the optimum level. The apparatus compares a present power value of an optical signal output from a laser diode (302) and controls an output of the laser diode according to the compared result. The apparatus includes sampling means (302) for sampling the present power value output from the laser diode; an arithmetic unit (306) for outputting a control power value applied to the laser diode, based on the present power value output from the sampling means and a reference power value; and a controller (312) for generating control signals, which control the operations of the sampling means and the arithmetic unit, based on write data to be recorded. The apparatus enhances the performance of high-speed and large-capacity optical recording/reproducing apparatuses, and further, minimizes the size of optical recording/reproducing apparatuses.

## Description

The present invention relates to an optical recording/reproducing apparatus, and more particularly, to a laser diode output control apparatus for controlling the output of a laser diode so that it is at the optimum level.

In today's Information Age, recording media having large capacities, e.g., optical recording apparatuses such as CD-R, CD-RW, MODD (Magnetic Optical Disc Drive), DVD-RAM (Digital Versatile Disc Random Access Memory), DVD-RW and DVD+RW, are required. These optical recording apparatuses use a laser diode and therefore, the performance of an optical recording apparatus depends on how well an output of the laser diode is controlled. In order to control an output of a laser diode so that it is at the optimum level, the shape of a write pulse that is required must be considered because it is different depending on the type of an optical recording apparatus.

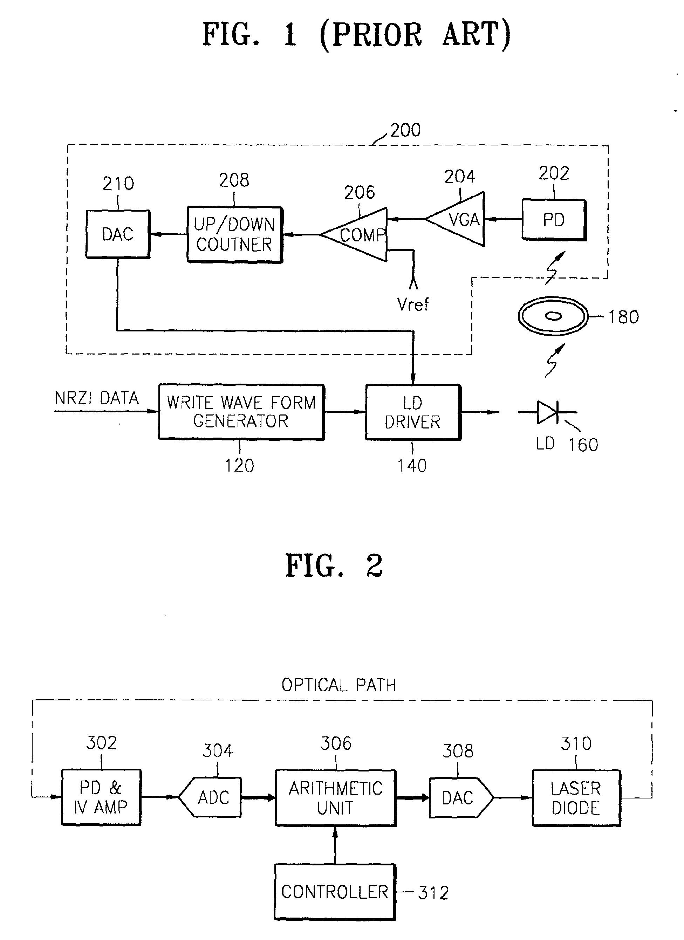

Figure 1 is a block diagram of a general laser diode output control apparatus. Referring to Figure 1, reference numeral '120' indicates a recording waveform generator for generating a write pulse so as to form a space or mark corresponding to recorded data on a disc 180. Reference numeral '140' indicates a laser diode driving unit for controlling an output of a laser diode 160 according to a write pulse generated in the recording waveform generator 120. Here, data input to the recording waveform generator 120 is a non return-to-zero inverted (NRZI) signal, and a write pulse output from the laser diode driving unit 140 is a combination of the first pulse, the last pulse, a cooling pulse, and a multi-train pulse in the case of DVD-RAM.

An auto laser power controller (APC) 200 includes a photo diode (PD) 202, a variable gain amplifier (VGA) 204, a comparator 206, an up/down counter 208 and a digital-to-analog converter (DAC) 210.

The PD 202 receives light from a laser reflected from a disc 180 and generates an electrical signal corresponding to the gain of the received light from laser. The VGA 204 amplifies the electrical signal generated in the PD 202 to a predetermined gain and converts the amplified electrical signal into a voltage signal. The comparator 206 compares the output of the VGA 204 and a reference power value Vref and outputs a determination signal that indicates which one of them is larger.

The up/down counter 208 counts up/down according to the determination signal output from the comparator 208. In detail, the up/down counter 208 counts down when the determination signal output from the comparator 206 indicates that the output of the VGA 204 is larger than the reference power value Vref; for example, have the determination signal may be at low level. In contrast, the up/down counter 208 counts up when the determination signal indicates that the output of the VGA 204 is smaller than the reference power value Vref; for example, have the determination signal may be at high level. The count of the up/down counter 208 is applied to the laser diode driving unit 140 via the DAC 210. The laser diode driving unit 140 controls an output level of the laser diode 160 according to the size of a signal applied to the DAC 210.

The APC circuit 200 shown in Figure 1 detects a difference between the reference power value Vref and the present power value of the laser diode 160 detected by the PD 202 and controls an output of the laser diode 160 according to a detected deviation.

The conventional laser diode output control apparatus shown in Figure 1 uses the up/down counter 208 in comparing the Vref and the present power value and controlling an output of the laser diode. However, as the reproducing and recording speed of a media becomes increasingly, the speed and range of controlling an output of a laser diode are limited by the working speed of the up/down counter 208. Further, if the recording speed of media increases, the width of a write pulse is reduced.

It is an aim of a present invention to provide a laser diode output control apparatus that has enhanced control speed and range.

According to the present invention there is provided a laser diode output control apparatus that compares a present power value of an optical signal output from a laser diode and controls an output of the laser diode according to the compared result, the apparatus comprising: sampling means for sampling the present power value output from the laser diode; an arithmetic unit for outputting a control power value applied to the laser diode, based on the present power value output from the sampling means and a reference power value; and a controller for generating control signals, which control the operations of the sampling means and the arithmetic unit, based on write data to be recorded.

Preferably, the sampling means comprises: a monitor diode for monitoring an output level of the laser diode; a current/voltage converter for converting an output of the laser diode into a voltage signal; and an analog/digital converter for sampling an output of the current/voltage converter.

Preferably, the apparatus comprises a preprocessor interposed between the current/voltage converter and the analog/digital converter, the preprocessor for controlling the gain of a signal output from the current/voltage converter.

Preferably, the preprocessor comprises: a read/write gain controller for controlling the gain of a signal output from the current/voltage converter in a read/write operational mode; and a gain select switch for selecting an output of the current/voltage converter or the read/write gain controller according to the operation of the controller and for providing the selected output to the analog/digital converter.

Preferably, the preprocessor further comprises: a low-pass filter for filtering an output of the gain select switch; a peak holder for holding a peak value from an output of the gain select switch; a bottom holder for holding a bottom value from an output of the gain select switch; and a mode select switch for selecting any one of the outputs of the low-pass filter, the gain select switch, the peak holder, and the bottom holder, according to the operation of the controller and providing the same to the analog/digital converter.

Preferably, the controller comprises: a write pulse generator for generating power control signals based on a non-return to zero inverted (NRZI) signal and generating a write control signal indicating power applied to the laser diode based on the power control signals; a sampling controller for generating a selection signal controlling the select operations of the sampling means and the arithmetic unit based on write control signals generated by the write pulse generator; and an APC controller for controlling the operational mode of the laser output control apparatus.

The apparatus preferably further comprises a delayer for delaying a write control signal and providing the same to the sampling controller, thereby compensating for the delay characteristics of the sampling means.

The apparatus preferably further comprises an interface for receiving a clock signal, a read/write control signal, an NRZI signal and a land/groove determination signal and providing the same to the APC controller.

Preferably the arithmetic unit comprises: reference registers for storing reference power values so as to control a power value of the output of the laser diode; control registers each for storing a power value to be applied to the laser diode; a subtracter for measuring a difference between reference power values stored in the reference registers and the present power values provided by the sampling means; an adder for adding an output of the subtracter and power values stored in the control registers; and a demultiplexer for selecting a control register among the control registers so as to store an output of the adder.

The apparatus preferably further comprises a divider interposed between the subtracter and the adder, the divider for decreasing an output of the adder and providing the decreased result to the adder.

The apparatus preferably further comprises an averaging unit for averaging outputs of the sampling means and providing the result to the subtracter.

Preferably, an output of the averaging unit is output for detection by an outer micro processor.

The apparatus preferably further comprises a first multiplexer for selecting one of the reference registers; and a second multiplexer for selecting one of the control registers and providing a power value stored in a selected control register to the adder, wherein the first and second multiplexers and the demultiplexer are synchronized by a selection signal generated by the controller.

The apparatus preferably further comprises a third multiplexer for selecting one of the control registers according to a write control signal generated by the controller; and a digital/analog converter for converting an output of the third multiplexer from a digital signal into an analog signal and providing the result to the laser diode.

The apparatus preferably further comprises a data output terminal for outputting a control power value stored in the selected control register to the outside.

The apparatus preferably further comprises a data input terminal for receiving a control power value, which is to be stored in the selected control register, from the outside.

For a better understanding of the invention, and to show how embodiments of the same may be carried into effect, reference will now be made, by way of example, to the accompanying diagrammatic drawings in which:
Figure 1 is a block diagram of a general automatic laser diode output control apparatus;
Figure 2 is a block diagram of a laser diode output control apparatus according to the present invention;
Figure 3 is a block diagram of the detailed structure of a laser diode output control apparatus according to the present invention;
Figure 4 is a block diagram of a preprocessor shown in Figure 3; and
Figure 5 is a block diagram of an arithmetic unit shown in Figure 3.

The laser diode output control apparatus shown in Figure 1 uses an up/down counter in comparing a reference power value and a present power value that is fed back and controlling an output of a laser diode according to the comparison result. For this reason, there is a limitation in controlling the speed and range of an output of the laser diode. Further, as the recording speed of media increases, a record pulse becomes shorter in length and more complicated. Therefore, it is difficult to cope with the tendency nowadays to increase the recording speed of recording media with the up/down counter.

To address these problems, the present invention provides an improved laser diode output control apparatus that samples and holds an output of a laser diode at a desired position for a desired period, compares the output of the laser diode with a reference power value, and controls the output of the laser diode.

Figure 2 is a block diagram of a laser diode output control apparatus according to the preferred embodiment of present invention. Referring to Figure 2, the apparatus includes a photo diode (PD) & current-to-voltage (I/V) amplifier 302, an analog-to-digital converter (ADC) 304, an arithmetic unit 306, a digital-to-analog converter (DAC) 308, a laser diode 310, and a controller 312.

The output of the laser diode 310 is determined by the output of the DAC 308. The PD & I/V amplifier 302 detects the level of the output and converts the output into a voltage signal.

The PD & I/V amplifier 302 has been usually manufactured on separate chips, but it is possible to combine a PD and an I/V amplifier on one chip. The output of the PD & I/V amplifier 302 indicates the present power value of a laser generated by the laser diode 310 and assumes the shape of a delayed write pulse output from the laser diode 310. Here, the amount of delay is changed depending on the operational characteristics of the laser diode 310 and the PD & I/V amplifier 302, but is almost fixed once the laser diode output control apparatus is completed.

The ACD 304 obtains the present power value by sampling the output of the PD & I/V amplifier 302 at a predetermined point of time and transmits the present power value to the arithmetic unit 306. Although not illustrated in Figure 2, a converter can be interposed between the ACD 304 and the PD & I/V amplifier 302. The operational characteristics of the PD & I/V amplifier 302 may be increased or decreased as the intensity of a laser becomes larger. Thus, there is a possibility that a converter is needed to match the operational characteristics of the PD & I/V amplifier 302 with those of the ADC 304.

A level shifter and/or a gain adjustor may be included at the front end of the ADC 304 to match the dynamic range of the ADC 304 with the output characteristics of the PD & I/V amplifier 302.

The arithmetic unit 306 compares a reference power value and the present power value sampled by the ADC 304 and controls the output of the laser diode 310 according to a difference between the reference power value and the present power value. Here, the reference power value may vary according to the type of media, a land/groove, the kind of power control signal, and so on. As described above, the arithmetic unit 306 compares a reference power value and the present power value sampled by the ADC 304 and corrects a control power value with a difference therebetween, and therefore, is capable of controlling the output of the laser diode 310 faster than an up/down counter used in a conventional laser diode output control apparatus.

The DAC 308 transmits the control power value measured by the arithmetic unit 308 to the laser diode 310.

The controller 312 generates control signals for controlling operations of the ADC 304 and the arithmetic unit 306 based on record data to be recorded, and further, controls the operations of the arithmetic unit 306 according to an operational mode.

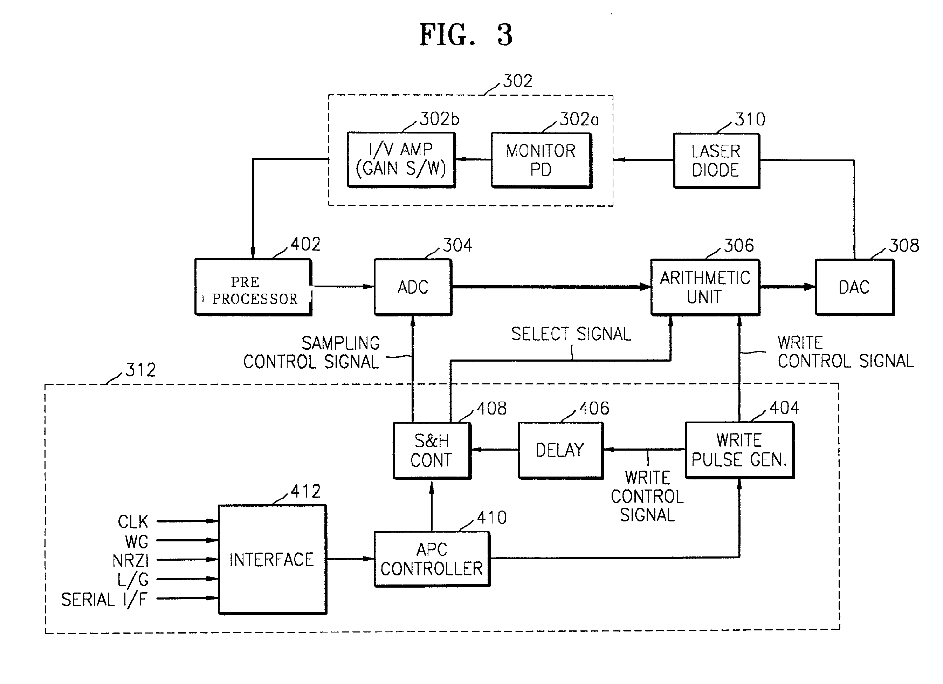

Figure 3 is a block diagram of the detailed structure of a laser diode output control apparatus according to the present invention. Referring to Figure 3, the laser output control apparatus includes a PD & I/V amplifier 302 composed of an I/V amplifier 302b and a monitor PD 302a, an ADC 304, an arithmetic unit 306, a DAC 308, a laser diode 310, a preprocessor 402, a write pulse generator 404, a delayer 406, a sample & hold controller 408, an APC controller 410 and an interface 412.

The write pulse output from the laser diode 310 is a multi pulse composed of a first pulse, a multi-pulse train, a last pulse, a cooling pulse, and so on. Each pulse constituting the write pulse is at a specific of power level, such as a read power level, a peak power level, a first bias (or erase) power level, a second (or cooling) bias power level, or a third bias (or bottom) power level. The power level of the write pulse changes with time to become another specific power level.

A write pulse is made based on a non return-to-zero inverted (NRZI) signal. In an adaptive recording method, the start/end position, width, and power level of each pulse are changed according to a relationship between spaces formed before and behind the present mark.

The write pulse generator 404 generates a write pulse by generating power control signals, i.e., a read power control signal, a peak power control signal, a first bias power control signal, a second bias power control signal, or a third power control signal, to turn on or off the power level of each write pulse, and then generates a write control signal by delaying the power control signals and combining logics thereof. The kind of power control signal generated by the write pulse generator 404 varies according to the type of media.

The arithmetic unit 306 outputs power levels such as a read power level, a peak power level, a first bias (or erase) power level, a second (or cooling) bias power level, and a third bias (or bottom) power level. The power levels output from the arithmetic unit 306 is controlled to be sequentially applied to the DAC 308 by a write control signal generated by the write pulse generator 404.

In the case of a general laser diode, a laser diode driver is attached thereto. Read power, peak power, first through third bias power, and power control signals, which control these powers, are applied to the laser diode driver. Each power is set to on or off by the corresponding power control signal, and the laser diode is driven according to a combination of results made by turning each power on/off.

The write pulse generator 404 may include pins, each outputting one of the power control signals to be applied to the laser diode driver. Through the write pulse generator 404, a read power level, a peak power level, a first bias (or erase) power level, a second bias (or cooling) power level, and a third bias (or bottom) power level, which are output from the arithmetic unit 306 and the DAC 308, are applied to the laser diode driver.

The ADC 304 samples the output from the PD & I/V amplifier 302 to obtain the present power value at a predetermined point in time and transmits the resultant to the arithmetic unit 306.

The arithmetic unit 306 compares a reference power value and the present power value sampled by the ADC 304 and sets control power values applied o the laser diode 310, i.e., read power, peak power, and first through third bias power, according to a difference between the reference power value and the present power value. Here, the reference power value is supplied from the APC controller 410 when the laser diode output control apparatus shown in Figure 3 is operated, and is changed depending on the type of media. The arithmetic unit 306 includes reference registers for storing reference power values, control registers for storing control powers applied to the laser diode 310, and a subtracter and an adder which measure a new control value using values stored in the reference registers and the control registers.

The write pulse generator 404 generates write pulse control signals, i.e., read power control signal, peak power control signal, and first through third bias power control signals, according to the type of media, an NRZI signal, and the relationship between a mark and spaces. Further, the write pulse generator 404 includes a plurality of delayers and a plurality of gates and generates a write control signal in delaying power level control signals generated and measuring logics thereof.

Here, the write control signal selects one of the control power values stored of control registers (not shown) of the arithmetic unit 306.

In the write pulse, read power, peak power, first bias power, second bias power and third bias power appear sequentially along an axis of time and sections of the write pulse are indicated by a read power control signal, a peak power control signal, a first bias power control signal, a second bias power control signal and a third bias power control signal, respectively. Thus, it is possible to measure the period during which each power is applied to a laser diode driver or controlled by combining the above power control signals with each other. The write pulse generator 404 combines the power control signals with each other and generates a write control signal indicating a section where each power must be applied to the laser diode 310.

The delayer 406 delays a write control signal generated in the write pulse generator 404. An output of the PD & I/V amplifier 302 assumes the shape of a delayed write pulse applied to the laser diode 310. Here, the amount of the delayed write pulse varies depending on the operational characteristics of the laser diode 310 and the PD & I/V amplifier 302 and is almost fixed when the laser diode output control apparatus is completed. The delayer 406 delays a sampling operation of the ADC 304 to compensate for a delay due to the PD & I/V amplifier 302.

The sample and hold controller 408 generates a sampling control signal that controls the sampling operation of the ADC 304 with a write control signal delayed by the delayer 406, and a selection signal that controls the operations of a multiplexer and a demultiplexer which are included in the arithmetic unit 406. The selection signal designates one of the sections in which a write pulse is divisionally indicated on an axis of time, where the sections denote periods of read power, peak power, first bias power, second bias power, and third bias power, which are applied to a laser diode driver.

The sampling control signal becomes a signal for controlling the sampling operation of the ADC 304 and sampling times are determined in sections in which read power, peak power, and first through third bias power are applied to the laser diode driver, respectively. For instance, a sampling time for sampling a read power can be alternatively selected in sections in which read power is applied, i.e., at a beginning part, a middle part or an end part. Further, the sampling time is determined by delaying write control signals or combining logic levels thereof.

Here, the sample & hold controller 408 decreases a write control signal generated by the write pulse generator 404 in half, in quarters and in eighths to adjust loop time.

The APC controller 410 receives information from the interface 412 to control the operations of the sample & hold controller 408 and the write pulse generator 404 according to the type of media, a land/groove, and a selected control mode.

The interface 412 inputs a clock signal *CLK*, a read/write control signal *WG*, NRZI signal *NRZI*, and a land/groove determination signal *L*/*G* to the APC controller 410 and receives the type of media and various control information to be interfaced from an external micro processor.

The APC controller 410 processes values sampled by the ADC 304 according to a selected control mode and controls the sample & hold controller 408 to provide processed values to the arithmetic unit 306. In the present invention, an average APC mode, a direct APC mode, a peak APC mode, and a bottom APC mode are suggested APC modes.

APC is controlled by the average between the previous laser diode output value and the present laser diode output value in an average APC mode and controlled by an output of the present laser diode output value in a direct APC mode. In both the peak APC mode and the bottom APC mode, APC is controlled by the present laser diode output value and a peak value or bottom value in a certain section.

In the laser diode output control apparatus shown in Figure 3, the write pulse generator 404, the delayer 406, and the sample & hold controller 408 may all be incorporated onto one integrated circuit. Also, the preprocessor 402, the ADC 304, the arithmetic unit 306, the DAC 308, the APC controller 410 and the interface 412 may be formed on one integrated circuit.

The reason the above devices are formed on one integrated circuit so that the laser diode output control apparatus can be attached to a pickup (not shown). Further, any disturbance occurring between elements can be prevented by putting the above devices on one integrated circuit, thereby effecting a stable laser output control operation. Particularly, in the case of high-capacity and high-speed optical recording/reproducing apparatuses, a signal exchanged between elements may have a high frequency. Such apparatuses are sensitive to outside disturbances and may easily malfunction. Malfunctions can be prevented by putting devices constituting the apparatus on one integrated circuit.

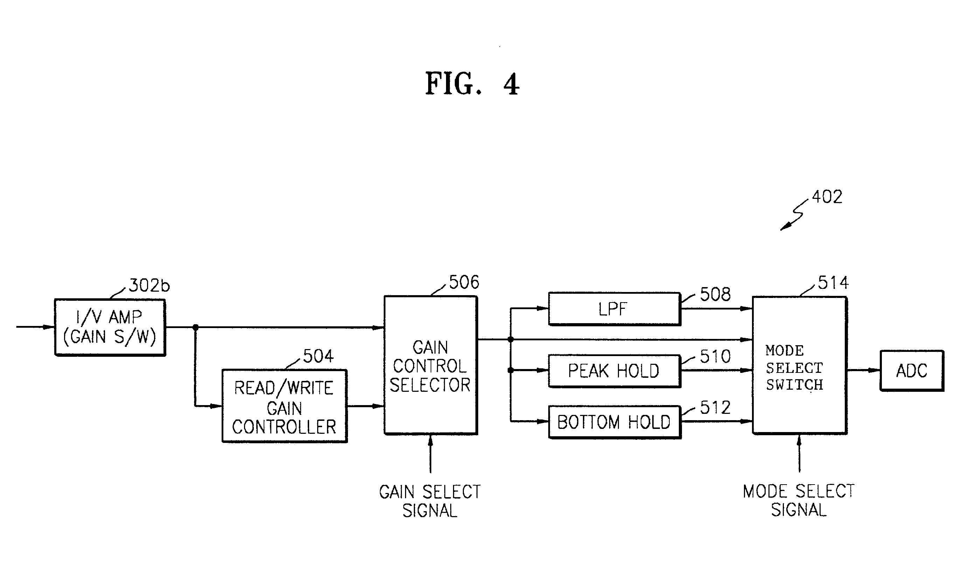

Figure 4 is a block diagram of the detailed structure of the preprocessor 402 shown in Figure 3. Referring to Figure 4, the preprocessor 402 includes a read/write gain controller 504, a gain control selector 506, a low-pass filter 508, a peak holder 510, a bottom holder 512, and a mode select switch 514.

The I/V amplifier 302b and the read/write gain controller 504 amplify a signal output from the PD & I/V amplifier 302 according to a given gain. Also, the I/V amplifier 302b and the read/write gain controller 504 adjust the gain to amplify the output of a monitor photo diode (PD) 302a according to a read mode or a write mode.

The gain control selector 506 is a switch for selecting one of the I/V amplifier 302b and the read/write gain controller 504 according to a gain selection signal applied from the APC controller 410.

The mode select switch 514 selects one of the signals provided by the low-pass filter 508, the gain control select switch 506, the peak holder 510, and the bottom holder 512 according to a mode select signal applied from the APC controller 410.

When the mode select signal indicates an average APC mode, the mode select switch 514 selects a signal provided by the low-pass filter 508 and outputs the same. The low-pass filter 508 averages the previous laser diode output value and the present laser diode output value and outputs the average value. When the mode selection signal indicates a direct APC mode, the mode select switch 514 selects a signal provided by the gain select switch 506 and outputs it. When the mode selection signal indicates a peak APC mode, the mode select switch 514 selects a signal provided by the peak holder 510 and outputs it. At this time, the peak holder 510 outputs the maximum value in a given section. Also, when the mode selection signal indicates a bottom APC mode, the mode select switch 514 selects a signal provided by the bottom holder 512 and outputs the signal. The bottom holder 512 outputs the minimum value in a given section.

The preprocessor 402 shown in Figure 4 can be formed as an integrated circuit.

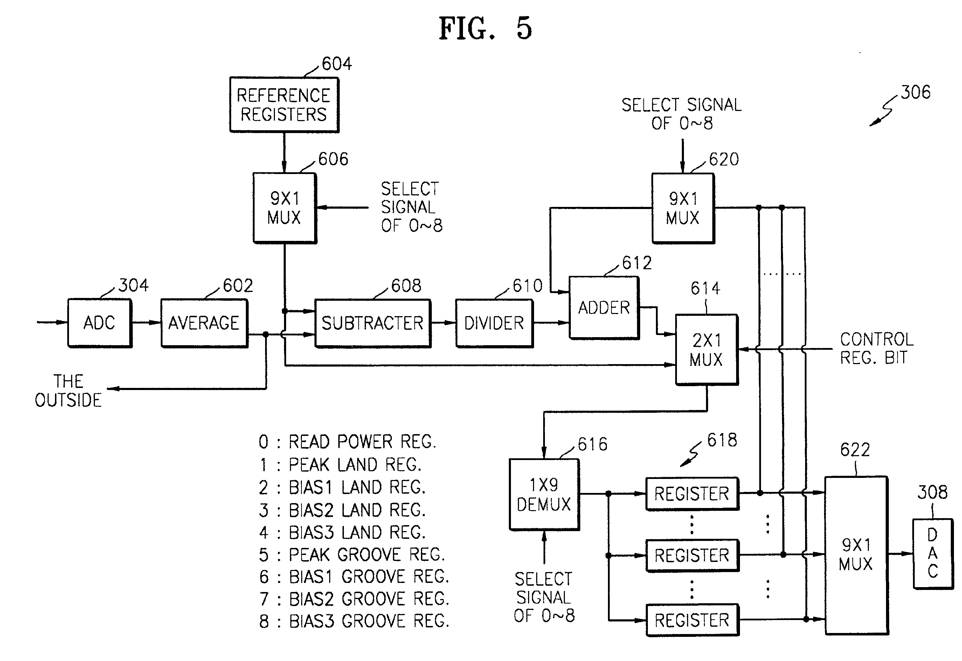

Figure 5 is a block diagram of the detailed structure of the arithmetic unit 306 shown in Figure 3. Referring to Figure 5, the arithmetic unit 306 includes an averaging unit 602, reference registers 604, a first multiplexer 606, a subtracter 608, a divider 610, an adder 612, a second multiplexer 614, a demultiplexer 616, control value registers 618, a third multiplexer 620, and a fourth multiplexer 622.

The averaging unit 602 removes sampling noise and performs low-pass filtering.

Output of the averaging unit 602 is sent to the subtracter 608 or the exterior so that an outer micro processor can detect the output of the laser diode 310 during a laser diode test.

In the reference registers 604, a total of nine registers are included in the present invention. The reference registers 604 store reference power values such as read power, peak power for a land, first through third bias power for a land, peak power for a groove, and first through third bias power for a groove. Here, the number of reference value registers may vary depending on the type of media and the number of power levels to be controlled.

Further, the apparatus shown in Figure 5 may further include a multiplexer (not shown) for assigning reference power values to the reference registers 605. The APC controller 410 receives reference power values from the interface 412 and stores the same in the reference registers 604 with help from the multiplexer. Otherwise, reference power values can be applied to the reference registers 604 directly from the multiplex by an external micro processor.

The first multiplexer 606 selects one of the reference registers 604.

The subtracter 608 measures the difference between the reference power value output from the reference registers 604 and the present power values output from the averaging unit 602 and outputs the difference.

The divider 610 outputs the difference measured by the subtracter 608, gradually decreasing the difference, e.g., in half, in quarters, in eights, and so on. As a result, a difference between the reference power value and the present power value obtained by the subtracter 608 can be reduced, thereby controlling the speed of tracking a target value.

The adder 612 adds the present power value provided by the laser diode 310 and the difference obtained by the divider 608 and outputs the resulting value. The output of the adder 612 is a value whose APC is amended, which later becomes a control power value to be supplied to the DAC 308 after being amended by the control registers 618, the third multiplexer 622, and the DAC 308.

The second multiplexer 614 is provided to store reference power values in the reference registers 604 in the control registers 618 when a laser diode control apparatus is initialized. That is, at this time, the second multiplexer 614 stores a reference power value output from a reference register 604 that has been selected by the first multiplexer 606, in a control register selected by the demultiplexer 616. The selecting of the second multiplexer 614 is controlled by the APC controller 410.

The demultiplexer 616 selects the control registers 618 that store control values obtained from the adder 612.

The control registers 618 store reference power values, which are provided to the laser diode 310, and includes nine registers that store read power, peak power for a land, first through third bias power for lands, peak power for a groove, and first through third bias power for grooves, respectively. Here, as with the reference registers 604, the number of the registers included in the control registers 618 may vary depending on the type of media and the number of power levels to be controlled.

Although not shown, data input/output terminals may be included in the apparatus shown in Figure 5 to provide or receive control power levels stored in the control registers 618 to or from an outer micro processor. In this case, it is possible for the outer micro processor to detect the present control power values in the control registers 618 through the data input terminals and to store a predetermined control power value in the control registers 618 via the data input terminals. In conclusion, it is possible to control a laser diode output control apparatus as done by firm ware.

The third multiplexer 620 selects a power value to be controlled.

The fourth multiplexer 622 selects a power value to be provided to the laser diode 310 when a write control signal generated by the write pulse generator 404 is input thereto.

In the apparatus shown in Figure 5, the selecting of the first multiplexer 604, the demultiplexer 616, and the third multiplexer 620 must be synchronized with one another and are determined by a selection signal generated by the sampling controller 408. For instance, read power can be controlled by selecting both a register that stores read power among the reference registers 604, and a register that stores read power among the control registers 618.

A selection signal, which controls the selecting of the first multiplexer 604, the demultiplexer 616, and the third multiplexer 620, is generated by the sampling controller 408.

Hereinafter, the operations of a laser diode output control apparatus according to the present invention will be described in detail with reference to Figures 3 through 5.

During a test on the output of a laser diode, the output characteristics of a laser diode is changed according to its working temperature. Thus, the characteristics of the laser diode must be considered prior to controlling the laser diode. To examine the output characteristics of a laser diode, predetermined control values are applied to the laser diode to measure outputs of the laser diode corresponding to the predetermined control values. As a result, an output characteristics curve can be obtained with the control values and the output values.

During the above examination, an output of the averaging unit 602 must be output to the outside, so that an output of the laser diode can be input to an outer micro processor. The present power value of laser output from the laser diode 310 is measured by applying a predetermined value to the ADC 304 via the external processor so as to detect an output of the averaging unit 602.

Regarding the initial setting of an optical disc recording control apparatus, the control registers 618, which store control values to control the output of the laser diode 310, must be initialized to have predetermined values before the laser diode 310 is operated. At this time, the APC controller 410 controls the second multiplexer 614 to receive the output of the first multiplexer 606.

The operations of the first multiplexer 606 and the demultiplexer 616 are controlled by selection signals generated by the sampling controller 408. For instance, when a selection signal indicates read power, a reference register stores read power is selected among the reference registers 604 by the first multiplexer 606, and a control register that stores read power is selected among the control registers 618 by the demultiplexer 616. That is, every time a selection signal indicates one of read power, peak power for a land, first through third bias power for lands, peak power for a groove, and first through third bias power for grooves, the corresponding control values are loaded into the control registers 618 from the reference registers 604.

In setting APC modes, a laser output control apparatus according to the present invention can be operated in an average APC mode, a direct APC mode, a peak APC mode and a bottom APT mode. These operational modes are selected by the APC controller 410.

The APC controller 410 controls the selecting of the multiplexer 514 shown in Figure 4 and sets the operational mode of the apparatus. For instance, when a selection signal applied to the multiplexer 514 indicates an average APC mode, the multiplexer 514 selects the output of the low-pass filter 508.

In adjusting power levels, a signal to be selected is set by the first multiplexer 606 and the third multiplexer 620. The first and third multiplexers 606 and 620 are controlled by a selection signal generated by the sampling APC controller 410.

The subtracter 608 compares the output of the averaging unit 602, i.e., the present output value of the laser diode 310 with a reference power value provided by a reference register, which is selected by the first multiplexer 606, and measures a difference therebetween.

The difference measured by the subtracter 608 is decreased by the divider 610 and then is provided to the adder 612.

The adder 612 adds the difference obtained by the divider 610 with a control power value provided by the third multiplexer 620 and provides the result to the demultiplexer 616. The demultiplexer 616 selects a control register among the control registers 618 to store a value provided by the adder 612.

As described above, a laser diode output control apparatus according to the present invention enhances the performance of high-speed and large-capacity optical recording/reproducing apparatuses.

Also, it is possible to minimize the size of optical recording/reproducing apparatuses by incorporating a laser diode output control apparatus, which is formed as an integrated circuit, into a pickup.

While this invention has been particularly shown and described with reference to preferred embodiments thereof, it will be understood by those skilled in the art that various changes in form and details may be made therein without departing from the scope of the invention as defined by the appended claims.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A laser diode output control apparatus that compares a present power value of an optical signal output from a laser diode and controls an output of the laser diode according to the compared result, the apparatus comprising:
sampling means (302) for sampling the present power value output from the laser diode;
an arithmetic unit (306) for outputting a control power value applied to the laser diode, based on the present power value output from the sampling means and a reference power value; and
a controller (312) for generating control signals, which control the operations of the sampling means and the arithmetic unit, based on write data to be recorded.

2. The apparatus of claim 1, wherein the sampling means (302) comprises:
a monitor diode (302a) for monitoring an output level of the laser diode;
a current/voltage converter (302b) for converting an output of the laser diode into a voltage signal; and
an analog/digital converter (304) for sampling an output of the current/voltage converter.

3. The apparatus of claim 2 further comprising a preprocessor (402) interposed between the current/voltage converter (302b) and the analog/digital converter (304), the preprocessor for controlling the gain of a signal output from the current/voltage converter.

4. The apparatus of claim 3, wherein the preprocessor (402) comprises:
a read/write gain controller (504) for controlling the gain of a signal output from the current/voltage converter in a read/write operational mode; and
a gain select switch (506) for selecting an output of the current/voltage converter or the read/write gain controller according to the operation of the controller and for providing the selected output to the analog/digital converter.

5. The apparatus of claim 4, wherein the preprocessor (402) further comprises:
a low-pass filter (508) for filtering an output of the gain select switch;
a peak holder (510) for holding a peak value from an output of the gain select switch;
a bottom holder (512) for holding a bottom value from an output of the gain select switch; and
a mode select switch (514) for selecting any one of the outputs of the low-pass filter, the gain select switch, the peak holder, and the bottom holder, according to the operation of the controller and providing the same to the analog/digital converter.

6. The apparatus of any of claims 1 to 5, wherein the controller (312) comprises:
a write pulse generator (404) for generating power control signals based on a non-return to zero inverted (NRZI) signal and generating a write control signal indicating power applied to the laser diode based on the power control signals;
a sampling controller (408) for generating a selection signal controlling the select operations of the sampling means and the arithmetic unit based on write control signals generated by the write pulse generator; and
an APC controller (410) for controlling the operational mode of the laser output control apparatus.

7. The apparatus of claim 6 further comprising a delayer (406) for delaying a write control signal and providing the same to the sampling controller, thereby compensating for the delay characteristics of the sampling means.

8. The apparatus of claim 6 or 7 further comprising an interface (412) for receiving a clock signal, a read/write control signal, an NRZI signal and a land/groove determination signal and providing the same to the APC controller.

9. The apparatus of any of claims 1 to 8, wherein the arithmetic unit (306) comprises:
reference registers (604) for storing reference power values so as to control a power value of the output of the laser diode;
control registers (618) each for storing a power value to be applied to the laser diode;
a subtracter (608) for measuring a difference between reference power values stored in the reference registers and the present power values provided by the sampling means;
an adder (612) for adding an output of the subtracter and power values stored in the control registers; and
a demultiplexer (616) for selecting a control register among the control registers (618) so as to store an output of the adder.

10. The apparatus of claim 9 further comprising a divider (610) interposed between the subtracter and the adder, the divider for decreasing an output of the adder and providing the decreased result to the adder.

11. The apparatus of claim 9 or 10 further comprising an averaging unit (602) for averaging outputs of the sampling means and providing the result to the subtracter.

12. The apparatus of claim 11, wherein an output of the averaging unit (602) is output for detection by an outer micro processor.

13. The apparatus of claim 9, 10, 11 or 12 further comprising:
a first multiplexer (606) for selecting one of the reference registers; and
a second multiplexer (620) for selecting one of the control registers and providing a power value stored in a selected control register to the adder (612),
wherein the first and second multiplexers (606,620) and the demultiplexer (616) are synchronized by a selection signal generated by the controller.

14. The apparatus of claim 13 further comprising:
a third multiplexer (622) for selecting one of the control registers according to a write control signal generated by the controller; and
a digital/analog converter (308) for converting an output of the third multiplexer from a digital signal into an analog signal and providing the result to the laser diode.

15. The apparatus of claim 13 or 14 further comprising a data output terminal for outputting a control power value stored in the selected control register to the outside.

16. The apparatus of claim 13, 14 or 15 further comprising a data input terminal for receiving a control power value, which is to be stored in the selected control register, from the outside.
